(19) **Europäisches Patentamt**

**European Patent Office**

**Office européen des brevets**

(11) Veröffentlichungsnummer: **0 176 746 B1**

(12) **EUROPÄISCHE PATENTSCHRIFT**

(51) Int. Cl.⁵: **H01L 21/60, H01L 23/48**

(45) Veröffentlichungstag der Patentschrift:
22.08.90

(21) Anmeldenummer: 85110604.7

(22) Anmeldetag: 23.08.85

(54) Erzeugung von Kupferhöckern für integrierte Schaltungen.

(30) Priorität: 20.09.84 DE 3434580

(43) Veröffentlichungstag der Anmeldung:
09.04.86 Patentblatt 86/15

(45) Bekanntmachung des Hinweises auf die Patenterteilung:
22.08.90 Patentblatt 90/34

(84) Benannte Vertragsstaaten:
AT CH DE FR GB IT LI NL

(56) Entgegenhaltungen:
FR-A-2 313 772
US-A-4 051 508

31st ELECTRONIC COMPONENTS CONFERENCE,
Mai 1981, Seiten 140-155, Atlanta, US; T. KAWANOBE
u.a.: "Solder bump fabrication by electrochemical
method for flip chip interconnection"
ELECTRONICS, Band 51, Nr. 14, Juli 1978,
Seiten 116-119, New York, US; D. DEVITT u.a.: "Beam
tape plus automated handling cuts IC maufacturing
costs"

(73) Patentinhaber: Siemens Aktiengesellschaft,
Wittelsbacherplatz 2, D-8000 München 2(DE)

(72) Erfinder: Andrascek, Ernst, Franz-Wolter-Strasse 13,
D-8000 München 81(DE)
Erfinder: Hadersbeck, Hans, Ing. grad.,
Pistorinistrasse 14, D-8000 München 21(DE)

ACTORUM AG

## Beschreibung

Die Erfindung betrifft ein Verfahren für die Erzeugung galvanisch aufgebauter Kupferhöcker auf integrierten Schaltungen und deren chemisch stromlose Metallisierung.

Es ist bekannt, auf einer Siliziumscheibe (Wafer) integrierte Schaltungen aufzubringen. Diese integrierten Schaltungen haben Anschlußpunkte bzw. -flächen für die elektrische Kontaktierung. Diese Kontaktflächen bestehen in der Regel aus Aluminium. Sie sind speziell für die Bondtechnik (Drahtverbindungstechnik) geeignet.

Andere Verbindungstechniken mit einer integrierten Schaltung (Mikropack), wie zum Beispiel die Löttechnik, erfordern für die Kontaktierung der Kontaktflächen mit dem integrierten Schaltkreis Höcker. Diese Höcker müssen sehr gut lötbar sein.

Zur Herstellung der Höcker werden die Kontaktflächen aus Aluminium hergestellt. Die mit Schutznitrid passivierte Halbleiterscheibe wird zunächst in einem naßchemischen Prozeß aktiviert und dann mit einer zum Beispiel 0,2 µm dicken Titanschicht und einer zum Beispiel 2 bis 3 µm dicken Kupferschicht bedampft. Darauf folgt erforderlichenfalls ein Temperprozeß des Wafers. Daran schließt sich mit der Fototechnik die Strukturierung der Kontaktflächen an, denen in einem Galvanikbad der Höckeraufbau folgt. Nach dem Galvanik-Kupfer-Höckeraufbau wird der Fotolack entschichtet und die dünne Kupferschicht sowie Titanschicht in entsprechenden Ätzmedien entfernt. Nach einer Aktivierung der Kupferhöcker werden diese in einem stromlosen Nickel- bzw. Goldbad metallisiert. Zur Minderung der störenden fotoelektrischen Effekte an PN/NP-Übergängen findet die stromlose Metallisierung im abgedunkelten Raum statt. Um eine Zerstörung der integrierten Schaltkreise auf dem Wafer zu verhindern, werden die Expositionszeiten in den stromlosen Bädern eng begrenzt.

Der Erfindung liegt die Aufgabe zugrunde, einen Verfahrensablauf zu entwickeln, bei dem die galvanisch aufgebauten Kupferhöcker auf mit Schutznitrid passivierten Halbleiterscheiben (Wafer) nach ihrer Fertigstellung ihre ballige glänzende Oberfläche beibehalten und zur Erzielung einer sehr guten Lötbarkeit mit einer gleichmäßig stromlos aufgebrachten Metallschicht aus Gold, Gold-Zinn, Nickel-Gold oder Zinn versehen sind.

Dabei soll der an PN/NP-Übergängen auftretende fotoelektrische Effekt total unterbunden werden, damit eine gleichmäßige stromlose Metallisierung aller Kupferhöcker möglich wird.

Außerdem sollen nach dem Verfahren die integrierten Schaltkreise während der galvanischen Höckererzeugung sowie der stromlosen Metallisierung aufgrund einer defekten Schutznitrid-Passivierung von chemischen Bädern nicht mehr zerstört werden können, unabhängig davon, wielange sie im galvanischen oder stromlosen Metallisierungsbad verweilen.

Die Schutznitrid-Passivierung soll nur möglichst geringer Beanspruchung durch chemische Lösungen ausgesetzt werden.

Das Verfahren nach der Erfindung besteht aus folgenden Schritten:

- Rücksputtern der nach einer partiellen Schutznitrid-Entfernung der freiliegenden Aluminiumkontaktflächen und Aufsputtern einer Titan- sowie einer Kupferschicht auf der gesamten Fläche des Wafers,
- galvanischer Aufbau der Kupferhöcker unter Verwendung einer Fotolackstruktur,
- Entfernen der aufgesputterten Kupferschicht in einer Ätze-Kupferglanzbeize bei Raumtemperatur,
- stromlose Metallisierung der Kupferhöcker und
- Entfernen der Titanschicht vom Wafer bis zum Höckerrand in einer Titanätze.

Die Titanschicht kann beispielsweise 0,1 µm und die Kupferschicht 0,5 µm dick sein.

Zur Erreichung optimaler Höckeroberflächen kann die dünne Kupferschicht in einer Ammoniumperoxodisulfatätze entfernt werden und anschließend die Kupferhöcker dann in einer Glanzbeize bei Raumtemperatur geglättet werden.

Ein wesentlicher Vorteil des erfindungsgemäßen Verfahrens besteht darin, daß das Rücksputtern einen umständlichen naßchemischen Prozeß zur Beseitigung des Aluminiumoxids vermeidet. Damit entfällt auch ein Temperprozeß. Die dünne Kupferschicht hat ferner den Vorteil einer guten Justierbarkeit der Maske für die Höckerstruktur. Darüber hinaus wird die Ätzzeit bei der Entfernung der Kupferschicht auf ein Mindestmaß reduziert.

Durch die Verwendung einer Kupferglanzbeize wird im Gegensatz zu einer Kupferätze die gute galvanische Oberfläche der Kupferhöcker nicht nachteilig verändert.

Die stromlose Metallisierung der Kupferhöcker erfolgt, während die gesamte Titanschicht noch vorhanden ist. Es wurde festgestellt, daß die stromlose Metallisierung selektiv nur auf Kupfer oder Nickel, jedoch nicht auf Titan abscheidet. Auf diese Weise besteht während der stromlosen Metallisierung ein dichter Lichtschutz und Kurzschluß der integrierten Schaltkreise, wodurch der störende Einfluß des fotoelektrischen Effektes ausgeschlossen wird. Dadurch läßt sich eine gleichmäßige Metallisierung aller Kupferhöcker erzeugen. Ein weiterer Vorteil durch die Titanschicht besteht darin, daß während der stromlosen Metallisierung die gesamte Scheibenoberfläche von chemischen Angriffen geschützt ist. Deshalb sind die Expositionszeiten in den Metallisierungsbädern nicht mehr kritisch.

Beim Entfernen der Titanschicht in einer Titanätze erfolgt kein Angriff der stromlos metallisierten Höcker.

Die Erfindung wird an einem Ausführungsbeispiel für einen Kupferhöcker erläutert:

Mit 1 ist eine Aluminiumkontaktfläche bezeichnet. Die gesamte Halbleiterscheibe - mit Ausnahme der Kontaktflächen 1 - ist mit Schutznitrid 2 abgedeckt. 3 kennzeichnet eine Titanschicht, die sich über die gesamte Fläche des Wafers erstreckt. Darauf wird eine Kupferschicht 4 aufgebracht, zum Beispiel aufgesputtert. Die Fotolackstrukturierung für den Höckeraufbau ist durch 5 angedeutet. 6 kennzeichnet den galvanischen Höckeraufbau, der mit Gold 7, Nickel-Gold oder anderen Metallen 8 abgedeckt ist. Anschließend wird die Kupferschicht 4 und die Titanschicht 3 von der Scheibe bis zum Höckerrand entfernt.

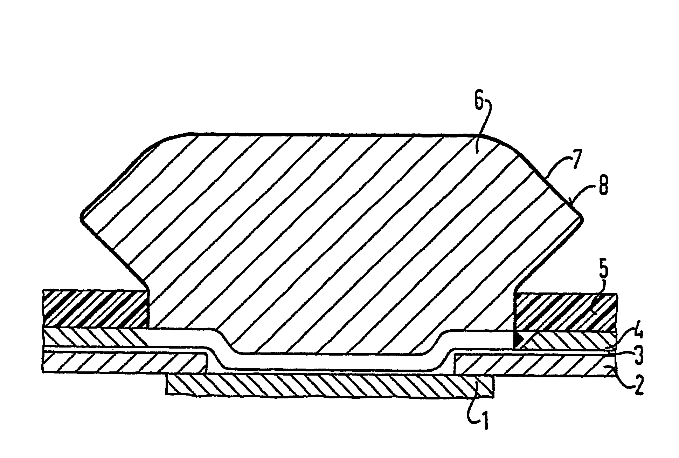

## Patentansprüche

1. Verfahren zur Erzeugung galvanisch aufgebauter Kupferhöcker auf Aluminiumkontaktflächen (1) aufweisenden integrierten Schaltungen und zu deren chemisch stromloser Metallisierung, das folgende Schritte umfaßt:
   - Rücksputtern der nach einer partiellen Schutznitrid-Entfernung freiliegenden Aluminiumkontaktflächen (1) und Aufsputtern einer Titan- (3) sowie einer Kupferschicht (4) auf der gesamten Fläche des Wafers,
   - galvanischer Aufbau der Kupferhöcker (6), unter Verwendung einer Fotolackstruktur (5),
   - Entfernen der aufgesputterten Kupferschicht (4) in einer Ätze-Kupferglanzbeize bei Raumtemperatur,
   - stromlose Metallisierung (7, 8) der Kupferhöcker (6) und
   - Entfernen der Titanschicht (3) vom Wafer bis zum Höckerrand in einer Titanätze.

2. Verfahren nach Anspruch 1, dadurch gekennzeichnet, daß die Titanschicht ca. 0,1 μm und die Kupferschicht ca. 0,5 μm dick ist.

3. Verfahren nach Anspruch 1, dadurch gekennzeichnet, daß zur Erreichung optimaler Höckeroberflächen (6) die dünne Kupferschicht (4) in einer Ammoniumperoxodisulfatätze entfernt wird und anschließend die Kupferhöcker in einer Glanzbeize bei Raumtemperatur geglättet werden.

## Claims

1. Method of manufacturing copper bumps built up by electroplating on integrated circuits having aluminium contact areas (1) and of electrolessly metallizing them chemically, which comprises the following steps:
   - back-sputtering of the aluminium contact areas (1) exposed after a partial removal of protective nitride and deposition by sputtering of a titanium layer (3) and also of a copper layer (4) on the entire surface of the wafer,
   - build-up by electroplating of the copper bumps (6) using a photoresist structure (5),
   - removal of the copper layer (4) deposited by sputtering in an etching solution and copper brightening bath at room temperature,
   - electroless metallization (7, 8) of the copper bumps (6), and
   - removal of the titanium layer (3) from the wafer up to the edge of the bump in a titanium etching solution.

2. Method according to Claim 1, characterized in that the titanium layer is approximately 0.1 μm thick and the copper layer is approximately 0.5 μm thick.

3. Method according to Claim 1, characterized in that to achieve optimum bump surfaces (6), the thin copper layer (4) is removed in an ammonium peroxodisulphate etching solution and the copper bumps are then polished in a brightening bath at room temperature.

## Revendications

1. Procédé pour former des plots de contact en cuivre sur des circuits intégrés comportant des surfaces de contact en aluminium (1) et réaliser leur métallisation chimique sans courant, ce procédé incluant les étapes suivantes, consistant à:
   - appliquer une rétropulvérisation cathodique sur les surfaces de contact en aluminium (1) mises à nu après une élimination partielle du nitrure de protection et déposer par pulvérisation une couche de titane (3) et une couche de cuivre (4) sur l'ensemble de la surface de la pastille,
   - déposer galvaniquement les plots de contact en cuivre (6), moyennant l'utilisation d'une structure (5) formée d'une laque photosensible,
   - éliminer la couche de cuivre (4) déposée par pulvérisation, dans un corrosif de brillantage du cuivre, à la température ambiante,
   - réaliser la métallisation sans courant (7, 8) des plots de contact en cuivre (6), et
   - éliminer la couche de titane (3) de la pastille jusqu'au niveau du bord du plot de contact, dans un agent de corrosion du titane.

2. Procédé suivant la revendication 1, caractérisé par le fait que la couche de titane possède une épaisseur d'environ 0,1 μm et que la couche de cuivre possède une épaisseur d'environ 0,1 μm.

3. Procédé suivant la revendication 1, caractérisé par le fait que pour obtenir des surfaces optimales (6) des plots de contact, on élimine la couche mince de cuivre (4) dans un agent corrosif formé de peroxodisulfate d'ammonium, et qu'on lisse ensuite la couche de cuivre dans un agent corrosif de brillantage à la température ambiante.